(19) Europäisches Patentamt
European Patent Office
Office européen des brevets

(11) **EP 3 327 853 A1**

(12) **EUROPEAN PATENT APPLICATION**

(43) Date of publication:
**30.05.2018 Bulletin 2018/22**

(51) Int Cl.:
**H01M 10/48** *(2006.01)*    *H01M 6/50* *(2006.01)*

(21) Application number: **16201025.0**

(22) Date of filing: **29.11.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicants:
• **ROBERT BOSCH GMBH**
**70442 Stuttgart (DE)**

• **Lithium Energy and Power GmbH & Co. KG**
**70469 Stuttgart (DE)**

(72) Inventors:
• **Mingirulli, Nicola**
**70197 Stuttgart (DE)**
• **Hiller, Martin Manuel**
**70469 Stuttgart (DE)**
• **Fuchs, Franz**
**70191 Stuttgart (DE)**

(54) **METHOD AND CIRCUIT ARRANGEMENT FOR PRE-INDICATION OF DENDRITE FORMATION IN AN ELECTRODE ASSEMBLY OF A BATTERY CELL AND BATTERY CELL**

(57) The invention concerns a method for pre-indication of dendrite formation in an electrode assembly (10) of a battery cell, the electrode assembly (10) containing an anode (11) and a cathode (12) that are separated from one another by means of a separator (18). Thereat, a concentration change of metal ions from a potential metal contamination in the battery cell is detected. The invention also concerns a circuit arrangement (45) for pre-indication of dendrite formation in an electrode assembly (10) of a battery cell, the electrode assembly (10) containing an anode (11) and a cathode (12) that are separated from one another by means of a separator (18), the separator (18) containing an electrically conductive additional layer (32). Thereat, a measuring instrument (40) for determining an electrode potential of the additional layer (32) is provided. The invention further concerns a battery cell comprising such a circuit arrangement (45).

FIG. 2

Printed by Jouve, 75001 PARIS (FR)

EP 3 327 853 A1

**Description**

The invention relates to a method for pre-indication of dendrite formation in an electrode assembly of a battery cell. The invention also relates to a circuit arrangement for pre-indication of dendrite formation in an electrode assembly of a battery cell as well as to a battery cell comprising an inventive circuit arrangement.

State of the Art

Electrical energy can be stored by means of batteries. Batteries change chemical energy into electrical energy. Particularly, rechargeable batteries are known that can be charged and discharged several times. Batteries or battery systems comprise several battery cells that are connected electrically in series or in parallel.

Especially, lithium ion battery cells are used in rechargeable batteries or battery systems. Lithium ion battery cells have a relatively high energy density. Lithium ion battery cells are used for instance in motor vehicles, in particular in electric vehicles (EV), in hybrid electric vehicles (HEV) and in plug-in hybrid vehicles (PHEV). Lithium ion battery cells may comprise one or more electrode assemblies.

Electrode assemblies have a positive electrode called cathode and a negative electrode called anode. The anode and the cathode are separated from one another by means of a separator. The electrodes of the battery cell are formed like foils and are wound with interposition of the separator to form an electrode roll, also referred to as jelly-roll. Alternatively, the electrodes can be layered to form an electrode stack.

The electrodes and the separator are surrounded by an electrolyte that is normally in liquid state or in solid state. The electrodes of the electrode assemblies are connected to terminals of the battery cell. The battery cell can be charged and discharged by means of the terminals.

The cathode and the anode each comprise a current collector on which an active material is applied. The current collector of the cathode is typically made of aluminium and the current collector of the anode is typically made of copper. The active material for the cathode is, for example, a metal oxide. The active material for the anode is, for example, graphite or silicon. In the active material of the anode and cathode lithium ions are intercalated.

In a charging process of the battery cell, the lithium ions are migrating from the cathode through the electrolyte towards the anode. Thereby, the lithium ions are stored into the active material of the anode reversibly. Simultaneously, electrons flow in an external circuit from the cathode to the anode. In a discharging process, electrons flow in an external circuit from the anode to the cathode, and lithium ions move within the battery cell from the anode to the cathode.

If metal contaminations, in particular copper, are introduced into the battery cell during the production process on the cathode side, said contaminations dissolve and deposit on the anode. Thus, metallic dendrites which grow from the anode to the cathode are formed. Such dendrites may create electrical short circuits within the battery cell.

Document US 2014/0329120 A1 discloses a battery cell with internal means for detecting a growing dendrite. Said means comprise a separator that includes at least one functional layer. The functional layer is in particular metallic and electrically conductive.

Document WO 2015/031334 A1 discloses a method for detecting dendrites within battery cells. Thereat, an electric field within the battery cells is measured by dint of appropriate sensors. If a dendrite is present, the electrical field in the battery cell is changing.

Document DE 10 2012 107 848 A1 discloses a multi-layer separator for a battery cell. The separator comprises at least two layers, whereat at least one of said layers contains a structure and a plurality of pores. The pores serve for absorption of liquid electrolyte.

Disclosure of the Invention

A method for pre-indication of dendrite formation in an electrode assembly of a battery cell is proposed. Thereat, the electrode assembly contains an anode and a cathode that are separated from one another by means of a separator.

According to the invention, a concentration change of metal ions from a potential metal contamination in the battery cell is detected. Said metal ions mean to derive from metal contamination only. In particular, lithium ions that serve for charge transport from the anode to the cathode and vice versa are not meant to be detected according to the invention.

Metal contaminations that are introduced into the battery cell are oxidized in the battery cell at the cathode and positive ions of said metal diffuse and migrate towards the anode. When such metal ions reach the anode, they are reduced there to metallic form and create thus dendrites which grow from the anode towards the cathode. Thus, before dendrites are growing and create short circuits, the change of concentration of positive metal ions is detected in the battery cell. Hence, detection of change of concentration of metal ions in a battery cell is an appropriate means for pre-indication of dendrite formation.

Common battery cells contain liquid electrolyte. Said electrolyte also dissolves metal contaminations when they are exposed to potentials higher than the redox potential of the metal. This is typically the case when these particles are in contact with the cathode. The metal ions are thus included in the liquid electrolyte. Hence, the concentration change of metal ions in the liquid electrolyte in the battery cell is detected.

An electrode potential of the metallic layer on the separator depends on the activity of the corresponding metal ions in the battery cell. The activity displays the effective concentration and is related to the concentration as seen in the following equation:

$$a(Cu^{2+}) = \gamma(Cu^{2+}) \cdot c(Cu^{2+})$$

with:

a = activity of Cu²⁺ ions
c = concentration of copper ions
$\gamma$ = activity coefficient

The activity is roughly equal to the concentration for diluted electrolytes. It usually rises when the concentration increases. In particular, the electrode potential of the metallic layer is rising when the concentration of metal ions in the battery cell, in particular in the electrolyte, is increasing.

Hence, according to a further development of the invention, the changing concentration of metal ions is detected via the change of the electrode potential of the coated separator, especially via the changing electrode potential of an electrically conductive additional layer of the separator.

Said electrically conductive additional layer of the separator is for example made of copper. When the metal ions derive from copper, then the electrode potential of the electrically conductive additional layer of the separator is given by the following Nernst-equation:

$$E = E^0 + \frac{RT}{zF} \ln \frac{a(\text{Cu}^{2+})}{a(\text{Cu}^{0})}$$

with:

E = electrode potential
E° = standard electrode potential of copper electrode
R = universal gas constant
T = absolute temperature in Kelvin
F = Faraday constant
a(Cu²⁺) = activity of copper ions
a(Cu°) = activity of reduced species
z = number of transmitted electrons

According to an advantageous embodiment of the invention, the electrode potential change of the electrically conductive additional layer of the separator is determined by measuring an internal voltage between the additional layer of the separator and the anode. A rising internal voltage is equivalent to a rising electrode potential of the additional layer of the separator.

According to an alternative embodiment of the invention, the electrode potential change of the electrically conductive additional layer of the separator is determined by measuring an internal voltage between the additional layer of the separator and the cathode.

Advantageously, the additional layer is made of copper, aluminium or titanium. If the additional layer is made of copper, a concentration change of copper ions can be detected. If the additional layer is made of aluminium, Cu²⁺ ions deposit onto the aluminium since Cu is nobler than Al. Afterwards this layer is also sensitive to Cu²⁺- ions. If the additional layer is made of titanium, Cu²⁺ ions deposit onto the titanium since Cu is nobler than Al. Afterwards this layer is also sensitive to Cu²⁺-ions.

Furthermore, a circuit arrangement for pre-indication of dendrite formation in an electrode assembly of a battery cell is proposed, whereat the electrode assembly contains an anode and a cathode that are separated from one another by means of a separator, whereat the separator contains an electrically conductive additional layer.

According to the invention, a measuring instrument for determining an electrode potential of the additional layer of the separator is provided.

According to an advantageous embodiment of the invention, the measuring instrument is a voltage meter that is connected between the additional layer of the separator and the anode. Said voltage meter allows measuring an internal voltage between the additional layer and the anode.

According to an alternative embodiment of the invention, the measuring instrument is a voltage meter that is connected between the additional layer of the separator and the cathode. Said voltage meter allows measuring an internal voltage between the additional layer and the cathode.

Advantageously, the additional layer is made of copper, aluminium or titanium. If the additional layer is made of copper, a concentration change of copper ions can be detected. If the additional layer is made of aluminium, Cu²⁺ ions deposit onto the aluminium since Cu is nobler than Al. Afterwards this layer is also sensitive to Cu²⁺- ions. If the additional layer is made of titanium, Cu²⁺ ions deposit onto the titanium since Cu is nobler than Al. Afterwards this layer is also sensitive to Cu²⁺-ions.

Preferably, the additional layer is porous and is, for example, formed like a net which includes meshes that resemble to pores and that allow ions to pass through. Hence, the ions can pass through the additional layer.

According to an advantageous embodiment of the invention, the additional layer is arranged between a base layer of the separator that is ion conductive and the cathode.

According to a further development of the invention, the additional layer is covered with a porous coating that is electrically insulating and ion conductive. Said coating advantageously prevents the additional layer from electrical contact to the cathode. This layer doesn't prevent from sensing the Cu-ions as it is ionically conductive.

Preferably, the coating is made of a polymer material. The coating can also be made of a ceramic or a composite of ceramics and a binder.

Thereat, the coating is preferably arranged on top of the additional layer and thus between the cathode and the additional layer.

Furthermore, a battery cell is proposed that comprises a circuit arrangement according to the invention.

A battery cell according to the invention is usable advantageously in particular in an electric vehicle (EV), in a hybrid electric vehicle (HEV) or in a plug-in hybrid vehicle (PHEV).

Advantages of the Invention

According to the invented method, a pre-indication of dendrite formation in an electrode assembly is possible before dendrites are growing and create short circuits. Hence, a protection for example by switching off the battery cell is possible before a dendrite is causing a short circuit which could otherwise lead to safety hazards. Said pre-indication can be made advantageously only by use of a voltage meter connected to the electrode assembly.

Brief Description of the Drawings

For a better understanding of the aforementioned embodiments of the invention as well as additional embodiments thereof, reference should be made to the description of embodiments below, in conjunction with the appended drawings showing:

Figure 1     a schematic view at a battery cell,

Figure 2     a schematic view at a circuit arrangement for pre-indication of dendrite formation in an electrode assembly of the battery cell shown in figure 1, and

Figure 3     a diagram showing an exemplary time response of pre-indication of dendrite formation in the electrode assembly shown in figure 2.

Hereinafter, preferred embodiments of the present invention will be described with reference to the drawings. The drawings only provide schematic views of the invention. Like reference numerals refer to corresponding parts, elements or components throughout the figures, unless indicated otherwise.

Description of Embodiments

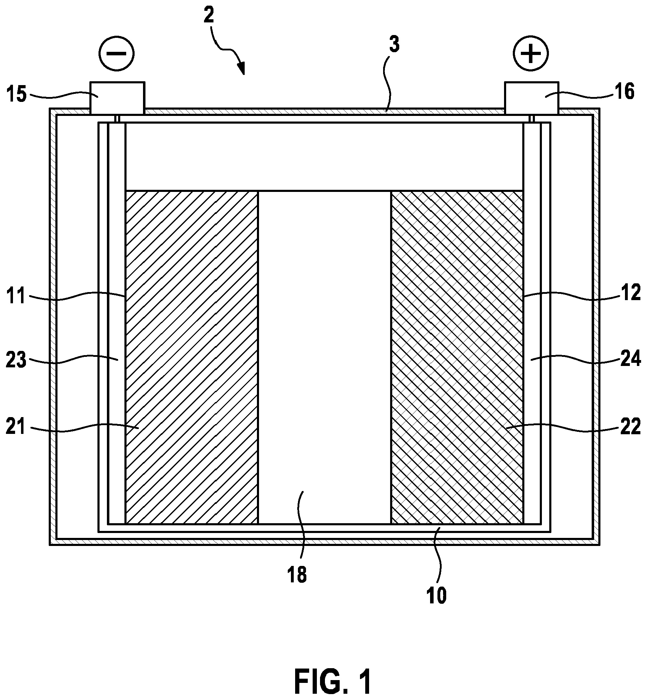

Figure 1 shows a schematic view at a battery cell 2. The battery cell 2 contains a housing 3 which has, for example, a prismatic or a cylindrical shape. The battery cell 2 further contains an electrode assembly 10, which is arranged within the housing 3.

The electrode assembly 10 contains an anode 11, a cathode 12 and a separator 18 that is arranged between the anode 11 and the cathode 12. Furthermore, the battery cell 2 contains a negative terminal 15 and a positive terminal 16. The terminals 15, 16 serve for charging and discharging the battery cell 2 and are mounted on the housing 3.

Presently, the electrode assembly 10 is shaped as a jelly roll. That means the anode 11 and the cathode 12 of the electrode assembly 10 are flat foils that are wound about an axis. The separator 18 that is also a flat foil is wound between the anode 11 and the cathode 12 about the same axis.

The housing 3 is filled with a liquid electrolyte such that the electrode assembly 10 is surrounded by the electrolyte. The separator 18, respectively parts of the separator 18, is soaked in said liquid electrolyte. The electrolyte is ion conductive.

The electrode assembly 10 can also be of pouch type, for example. That means the anode 11 and the cathode 12 of the electrode assembly 10 consist of several flat foils that are stacked alternately to form a pile or a stack. The separator 18 also consists of several flat foils that are stacked between the foils of the anode 11 and the foils of the cathode 12. A bag or a pouch made of an electrically insulating material surrounds the electrode assembly 10 such that the electrode assembly 10 is electrically insulated.

The anode 11 contains an anode active material 21 formed as a flat foil and an anode current collector 23 formed as a flat foil. The anode active material 21 and the anode current collector 23 are attached to one another. The anode current collector 23 is electrically conductive and is made of a metal, in particular of copper. The anode current collector 23 is electrically connected to the negative terminal 15 of the battery cell 2.

The cathode 12 contains a cathode active material 22 formed as a flat foil and a cathode current collector 24 formed as a flat foil. The cathode active material 22 and the cathode current collector 24 are attached to one another. The cathode current collector 24 is electrically conductive and is made of a metal, in particular of aluminium. The cathode current collector 24 is electrically connected to the positive terminal 16 of the battery cell 2.

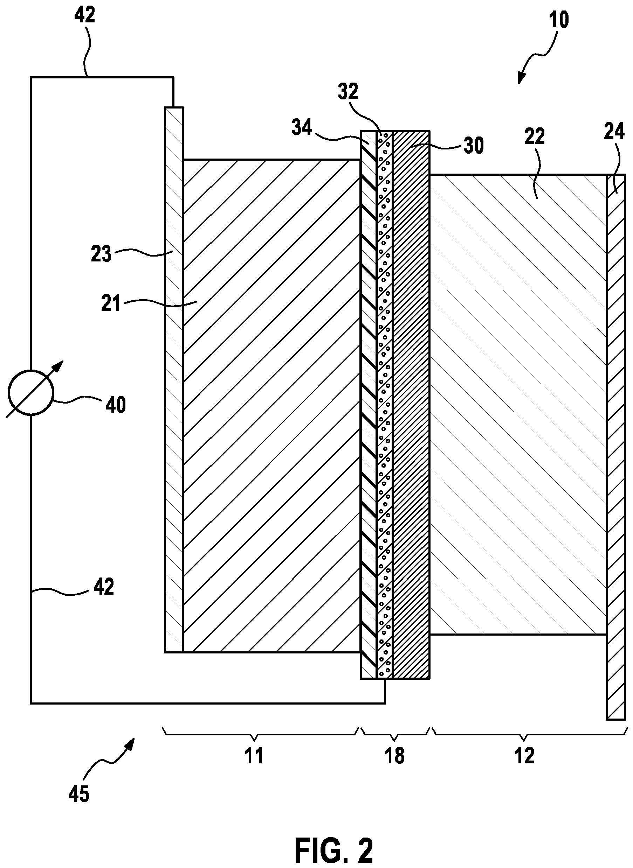

Figure 2 shows a schematic and detailed view at a circuit arrangement 45 for pre-indication of dendrite formation in the electrode assembly 10 of the battery cell 2 shown in figure 1. As described above, the electrode assembly 10 is shaped as a jelly roll. Here, a schematic sectional view of the electrode assembly 10 embedded in the circuit arrangement 45 is given.

The separator 18 of the electrode assembly 10 contains a base layer 34, an additional layer 32 and a coating 30. The additional layer 32 is in direct contact to the base layer 34. The coating 30 is applied to a far side of the additional layer 32 in respect to the base layer 34. That means, the additional layer 32 is arranged between the base layer 34 and the coating 30.

The base layer 34 of the separator 18 is ion conductive and electrically insulating. The additional layer 32 of the separator 18 is also ion conductive and electrically conductive. The additional layer 32 of the separator 18 is made of a metal, presently of copper. The additional layer 32 can for example also be made of titanium, or aluminium. The additional layer 32 is porous and is presently formed like a net which includes meshes, respectively pores. Said pores allow ions to pass through.

The coating 30 of the separator 18 that the additional layer 32 is coated with, is made of a porous polymer. The coating 30 can also be made of a ceramic, e. g. Al2O3, ZrO2, or a composite of ceramics and a binder (e.g. Al2O3 + PVdF). Hence, the coating 30 of the separator 18 is permeable for ions and thus ion conductive. But, the coating 30 of the separator 18 is electrically insulating.

The separator 18 is arranged within the electrode assembly 10 such that the base layer 34 of the separator 18 is in direct contact with the anode active material 21. The coating 30 on the additional layer 32 of the separator 18 is in direct contact with the cathode active material 22. Thus, the base layer 34 is arranged between the additional layer 32 and the anode 11. The coating 30 is arranged between the additional layer 32 and the cathode 12.

The circuit arrangement 45 also contains a measuring instrument 40 which is connected to the electrode assembly 10. Thereat, the measuring instrument 40 is connected via a wire 42 to the additional layer 32 of the separator 18 and via another wire 42 to the anode current collector 23. Thus, the measuring instrument 40 is connected between the additional layer 32 of the separator 18 and the anode 11.

The measuring instrument 40 is a voltage meter and hence the measuring instrument 40 allows measuring an internal voltage Ui between the additional layer 32 of the separator 18 and the anode current collector 23.

Alternatively or additionally, another measuring instrument 40, in particular another voltage meter, could be connected to the additional layer 32 of the separator 18 and to the cathode current collector 24. In that case, the measuring instrument 40 would allow measuring an internal voltage Ui between the additional layer 32 of the separator 18 and the cathode current collector 24.

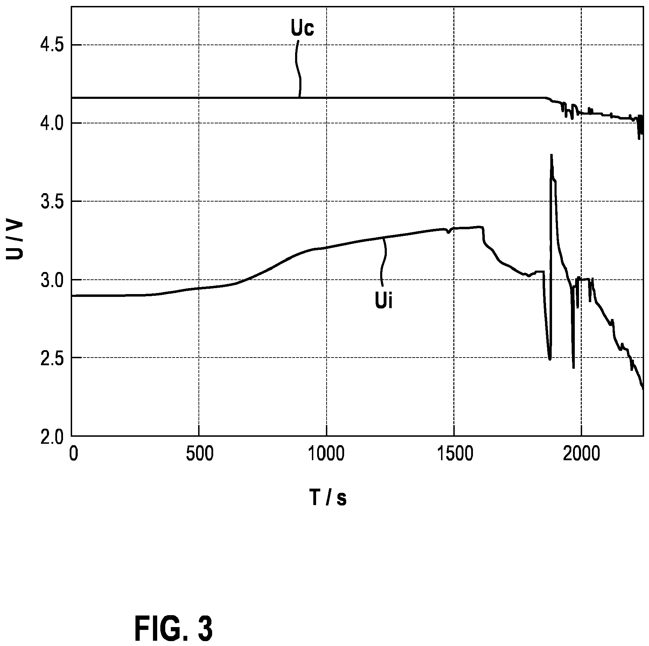

Figure 3 shows a diagram showing an exemplary time response of pre-indication of dendrite formation in the electrode assembly 10 by dint of the circuit arrangement 45 shown in figure 2. In the given diagram the x-axis shows elapsed time T measured in seconds (s) and the y-axis shows voltage U measured in volts (V).

For reference purpose, the diagram shows a cell voltage Uc which is a voltage between the positive terminal 16 and the negative terminal 15 of the battery cell 2. The cell voltage Uc corresponds to a voltage between the cathode current collector 24 and the anode current collector 23 and hence corresponds to a voltage between the cathode 12 and the anode 11.

The diagram also shows the internal voltage Ui between the separator 18 and the anode 11. Said voltage corresponds to a voltage between the additional layer 32 of the separator 18 and the anode current collector 23 that is measured with the measuring instrument 40 which is a voltage meter.

At a time T = 0 s, dissolution of metal contaminations, presently contamination of copper, in the battery cell 2 starts. Thus, the concentration of metal ions in the battery cell 2, in particular in the liquid electrolyte, is increasing.

About a time T = 500 s, the internal voltage Ui is rising about 25 mV. Said raise in the internal voltage Ui is an indication of an increased concentration of metal ions in the battery cell 2. Hence, said measured rise of the internal voltage Ui is usable as a pre-indication of an upcoming dendrite formation within the electrode assembly 10 of the battery cell 2.

In the following time T, the concentration of metal ions increases further and in parallel, a dendrite is growing within the battery cell 2 and the internal voltage Ui is rising further. About a time T = 1670 s, a dendrite has grown and has caused a short circuit within the battery cell 2 between the anode 11 and the additional layer 32 of the separator 18. Thus, a drop of the internal voltage Ui is measured.

In the following time T, the internal voltage Ui is alternating. This behaviour is caused by further dendrites. When a connection to the cathode 12 is generated, the internal voltage Ui is rising. A relation of resistances of the dendrites between the anode 11 and the additional layer 32 and of the dendrites between the cathode 12 and the additional layer 32 affects the potential of the anode 11 and of the cathode 12.

As can be seen, after about 500 seconds a pre-indication of an upcoming dendrite formation within the electrode assembly 10 of the battery cell 2 is possible although a short circuit caused by a grown dendrite is coming up only after about 1670 seconds. Hence, the pre-indication of an upcoming dendrite formation in the electrode assembly 10 of the battery cell 2 according to the invention is about three times faster than the detection of the short circuit caused by the dendrite.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings and those encompassed by the attached claims. The embodiments were chosen and described in order to explain the principles of the invention and its practical applications, to thereby enable others skilled in the art to utilize the invention and various embodiments with various modifications as are suited to the particular use contemplated.

**Claims**

1. Method for pre-indication of dendrite formation in an electrode assembly (10) of a battery cell (2), the electrode assembly (10) containing an anode (11) and a cathode (12) that are separated from one another by means of a separator (18), whereat a concentration change of metal ions from a potential metal contamination in the battery cell (2) is detected.

2. The method according to claim 1, **characterised in that** the concentration change of metal ions in liquid electrolyte in the battery cell (2) is detected.

3. The method according to one of the preceding claims, **characterised in that** the concentration change of metal ions is detected via the change of the electrode potential of an electrically conductive additional layer (32) of the separator (18).

4. The method according to claim 3, **characterised in that** the electrode potential change of the electrically conductive additional layer (32) is determined by measuring an internal voltage (Ui) between the additional layer (32) and the anode (11).

5. The method according to claim 3 or 4, **characterised in that** the electrode potential change of the electrically conductive additional layer (32) is determined by measuring an internal voltage (Ui) between the additional layer (32) and the cathode (12).

6. The method according to one of claims 3 to 5, **characterised in that** the additional layer (32) is made of copper, aluminium or titanium.

7. Circuit arrangement (45) for pre-indication of dendrite formation in an electrode assembly (10) of a battery cell (2), the electrode assembly (10) containing an anode (11) and a cathode (12) that are separated from one another by means of a separator (18), the separator (18) containing an electrically conductive additional layer (32), **characterised in that** a measuring instrument (40) for determining an electrode potential of the additional layer (32) is provided.

8. Circuit arrangement (45) according to claim 7, **characterised in that** the measuring instrument (40) is a voltage meter that is connected between the additional layer (32) and the anode (11).

9. Circuit arrangement (45) according to claim 7 or 8, **characterised in that** the measuring instrument (40) is a voltage meter that is connected between the additional layer (32) and the cathode (12).

10. Circuit arrangement (45) according to one of claims 7 to 9, **characterised in that** the additional layer (32) is made of copper, aluminium or titanium.

11. Circuit arrangement (45) according to one of claims 7 to 10, **characterised in that** the additional layer (32) is porous.

12. Circuit arrangement (45) according to one of claims 7 to 11, **characterised in that** the additional layer (32) is arranged between a base layer (34) of the separator (18) that is ion conductive and the cathode (12).

13. Circuit arrangement (45) according to one of claims 7 to 12, **characterised in that** the additional layer (32) is covered with a porous coating (30) that is electrically insulating and ion conductive.

14. Circuit arrangement (45) according to claim 13, **characterised in that** the coating (30) is made of a polymer material.

15. Circuit arrangement (45) according to one of claims 13 to 14, **characterised in that** the coating (30) is arranged between the additional layer (32) and the cathode (12).

16. Battery cell (2), comprising a circuit arrangement (45) according to one of claims 7 to 15.

17. Usage of a battery cell (2) according to claim 16 in an electric vehicle (EV), in a hybrid electric vehicle (HEV) or in a plug-in hybrid vehicle (PH EV).

**FIG. 1**

**FIG. 2**

FIG. 3

Europäisches
Patentamt

European
Patent Office

Office européen
des brevets

# EUROPEAN SEARCH REPORT

Application Number

EP 16 20 1025

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2016 143546 A (TOYOTA MOTOR CORP) 8 August 2016 (2016-08-08) * paragraphs [0016], [0031] - [0034]; figures 1,2 * | 1,2 | INV. H01M10/48 ADD. H01M6/50 |
| X | US 2015/171398 A1 (ROUMI FARSHID [US]) 18 June 2015 (2015-06-18) * paragraphs [0151], [0152], [0154]; figures 3B, 4B * | 7-17 | |
| A | US 2015/004450 A1 (MATSUMURA NAOKI [US]) 1 January 2015 (2015-01-01) * paragraphs [0012] - [0014]; figure 1 * | 1-17 | |

TECHNICAL FIELDS
SEARCHED        (IPC)

H01M

The present search report has been drawn up for all claims

| Place of search | Date of completion of the search | Examiner |
|---|---|---|
| Munich | 9 February 2017 | Meini, Stefano |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 16 20 1025

This annex lists the patent family members relating to the patent documents cited in the above-mentioned European search report.
The members are as contained in the European Patent Office EDP file on
The European Patent Office is in no way liable for these particulars which are merely given for the purpose of information.

09-02-2017

| Patent document cited in search report | | Publication date | Patent family member(s) | | Publication date |
|---|---|---|---|---|---|
| JP 2016143546 | A | 08-08-2016 | NONE | | |
| US 2015171398 | A1 | 18-06-2015 | US 2015171398 A1 | | 18-06-2015 |
| | | | US 2015180000 A1 | | 25-06-2015 |
| | | | WO 2015074037 A2 | | 21-05-2015 |
| | | | WO 2015074065 A1 | | 21-05-2015 |
| US 2015004450 | A1 | 01-01-2015 | CN 105393401 A | | 09-03-2016 |
| | | | EP 3014692 A1 | | 04-05-2016 |
| | | | US 2015004450 A1 | | 01-01-2015 |
| | | | WO 2014209992 A1 | | 31-12-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140329120 A1
- WO 2015031334 A1
- DE 102012107848 A1